(19) **Europäisches Patentamt**

**European Patent Office**

**Office européen des brevets**

(11) **EP 0 729 229 B1**

(12) **EUROPÄISCHE PATENTSCHRIFT**

(45) Veröffentlichungstag und Bekanntmachung des Hinweises auf die Patenterteilung:
**06.06.2001 Patentblatt 2001/23**

(51) Int Cl.$^7$: **H03H 21/00**

(21) Anmeldenummer: **96101761.3**

(22) Anmeldetag: **07.02.1996**

(54) **Adaptives Balancefilter**

Adaptive balance filter

Filtre d'équilibrage adaptatif

(84) Benannte Vertragsstaaten:
**CH DE ES FR GB IT LI NL SE**

(30) Priorität: **23.02.1995 DE 19506324**

(43) Veröffentlichungstag der Anmeldung:
**28.08.1996 Patentblatt 1996/35**

(73) Patentinhaber: **Infineon Technologies AG**
**81669 München (DE)**

(72) Erfinder: **Degenhardt, Achim, Dipl.-Ing.**
**D-82110 Germering (DE)**

(74) Vertreter: **Zedlitz, Peter, Dipl.-Inf. et al**
**Patentanwalt,**
**Postfach 22 13 17**
**80503 München (DE)**

(56) Entgegenhaltungen:
**EP-A- 0 491 063       EP-A- 0 508 847**

- **POOLE S J ET AL: "A CMOS SUBCRIBER LINE AUDIO PROCESSING CIRCUIT INCLUDING ADAPTIVE BALANCE" PROCEEDINGS OF THE INTERNATIONAL SYMPOSIUM ON CIRCUITS AND SYSTEMS, ESPOO, FINLAND, JUNE 7 - 9, 1988, Bd. 2 OF 3, 7.Juni 1988, INSTITUTE OF ELECTRICAL AND ELECTRONICS ENGINEERS, Seiten 1931-1934, XP000124806**

## EP 0 729 229 B1

**Beschreibung**

Die Erfindung betrifft ein adaptives Balancefilter

Mit einem adaptiven Filter, das einen Signalausgang, einen Koeffizientenausgang zur Ausgabe seiner Filterkoeffizienten, einen Fehlersignaleingang sowie einen mit einem Sendeweg gekoppelten Signaleingang aufweist,
mit einem Hauptfilter, das einen Signalausgang, einen mit dem Sendeweg gekoppelten Signaleingang sowie einem Koeffizienteneingang zum Laden von Filterkoeffizienten aufweist,
mit einem ersten Subtrahierer, dessen einer Eingang mit einem Empfangsweg und dessen anderer Eingang mit dem Ausgang des Hauptfilters gekoppelt ist und dessen Ausgang den weiteren Verlauf des Empfangsweges bildet,
mit einem zweiten Subtrahierer, dessen einer Eingang mit dem Empfangsweg, dessen anderer Eingang mit dem Signalausgang des adaptiven Filters und dessen Ausgang mit dem Fehlersignaleingang des adaptiven Filters gekoppelt ist,
mit einer Transfereinrichtung, die zwischen den Koeffizientenausgang des adaptiven Filters und den Koeffizienteneingang des Hauptfilters geschaltet ist und die einen Steuereingang für das Laden der Filterkoeffizienten des adaptiven Filters in das Hauptfilter bei Auftreten eines entspechenden Ladesignals aufweist sowie
mit einer Transfersteuereinrichtung.

Derartige Balancefilter sind beispielsweise aus S.J.Poole, G.Surace, B.Singh, N.P.Dyer, A CMOS Subscriber Line Audio Processing Cirucit Including Adaptive Balance, International Symposium on Circuits and Systems, Helsinki June 7-9, 1988, Seiten 1931 bis 1934, sowie aus der europäischen Patentanmeldung 0 491 063 bekannt. Dabei erfolgt das Laden der Koeffizienten des adaptiven Filters in das Hauptfilter nach unterschiedlichen Kriterien, die nur bei einem Teil der möglichen Betriebsfälle zu optimalen Ergebnissen führen.

Aufgrund der Zweidrahtübertragung sind auf den Anschlußleitungen eines Telefons die Sende- und Empfangssignale beider Teilnehmer gleichzeitig vorhanden. Die Übertragungsrichtungen werden in einer Brückenschaltung (Gabel) voneinander getrennt, wobei die Entkopplung der Signalwege von der Anpassungsgüte der Leitungsnachbildung an die Leitungsimpedanz abhängt. Es entsteht eine direkte Einkopplung des Sendesignals (Signal des einen Teilnehmers) in den Empfangskanal seines Telefons, die sich als Gabelübertragungsdämpfung angeben läßt. Das Empfangssignal besteht somit aus zwei Komponenten. Zum einen beinhaltet es das von der Anschlußleitung ankommende Signal (Signal des anderen Teilnehmers), als auch das eingekoppelte Sendesignal. Das eingekoppelte Sendesignal wird von dem einen Teilnehmer als Echo empfunden.

Da die Impedanzen der Teilnehmeranschlußleitungen variieren können und darüber hinaus auch verbindungsabhängig sind, ändert sich die Gabelübergangsdämpfung bei Verwendung einer festen Leitungsnachbildung über einen großen Bereich. In dem Fall, daß die Anpassung optimal ist, werden sehr große Dämpfungen erzielt. In dem Fall einer offenen Leitung dagegen kann sie sogar negativ sein. Dabei würde das Sendesignal verstärkt in den Empfangskanal zurückgeführt werden.

Beispielsweise bei drahtgebundenen Telefonen ist das eingekoppelte Sendesignal aufgrund der geringen Signallaufzeit zwischen Mikrofon und Lautsprecher nicht störend. Bei einem drahtlosen Telefon, das ein Zeitschlitzmultiplexverfahren verwendet, wird dagegen das eingekoppelte Sendesignal aufgrund der relativ hohen Signallaufzeiten zwischen dem Mikrofon und dem Lautsprecher als sehr störend empfunden.

Ziel der Erfindung ist es daher, ein adaptives Balancefilter anzugeben, das in jeder Betriebsweise eine optimale Leitungsanpassung gewährleistet.

Zur Lösung des Problems wird erfindungsgemäß vorgeschlagen, bei einem adaptiven Balancefilter der eingangs genannten Art eine Transfersteuereinrichtung mit drei Eingängen vorzusehen, von denen der erste mit dem Ausgang des zweiten Subtrahierers, der zweite mit dem einen Eingang des zweiten Subtrahierers und der dritte mit dem Ausgang des Hauptfilters gekoppelt ist, wobei die Transfersteuereinrichtung aus den an den drei Eingängen anliegenden Signalen die Echodämpfungen von adaptivem Filter und Hauptfilter ermittelt, die beiden Echodämpfungen miteinander vergleicht und im Falle einer gegenüber dem Hauptfilter höheren Echodämpfung des adaptiven Filters der Transfereinrichtung ein entsprechendes Kopiersignal zuführt.

Vorteil der Erfindung ist es, daß mit verhältnismäßig geringem Aufwand bei sämtlichen möglichen Betriebsfällen eine derart hohe Anpassungsgüte erzielt wird, daß sie den Anforderungen des DECT-Standards (DECT = Digital European Cordless Telefon), der ein Zeitschlitzmultiplexverfahren vorsieht, genügt.

Ausgestaltungen und Weiterbildungen des Erfindungsgedankens sind Gegenstand von Unteransprüchen.

Die Erfindung wird nachfolgend anhand der in den Figuren der Zeichnung dargestellten Ausführungsbeispiele näher erläutert.
Es zeigt:

Figur 1      die grundlegende Struktur eines erfindungsgemäßen adaptiven Balancefilters in einem Blockdiagramm,
Figur 2      eine bevorzugte Ausführungsform einer Qualitätsvergleichseinrichtung bei einem erfindungsgemäßen adaptiven Balancefilter nach Figur 1,

Figur 3    eine bevorzugte Ausführungsform eines in der Transfereinrichtung nach Figur 2 enthaltenen Tiefpasses und

Figur 4    eine bevorzugte Ausführungsform einer Betriebsartenerkennung bei der Transfersteuereinrichtung nach Figur 2.

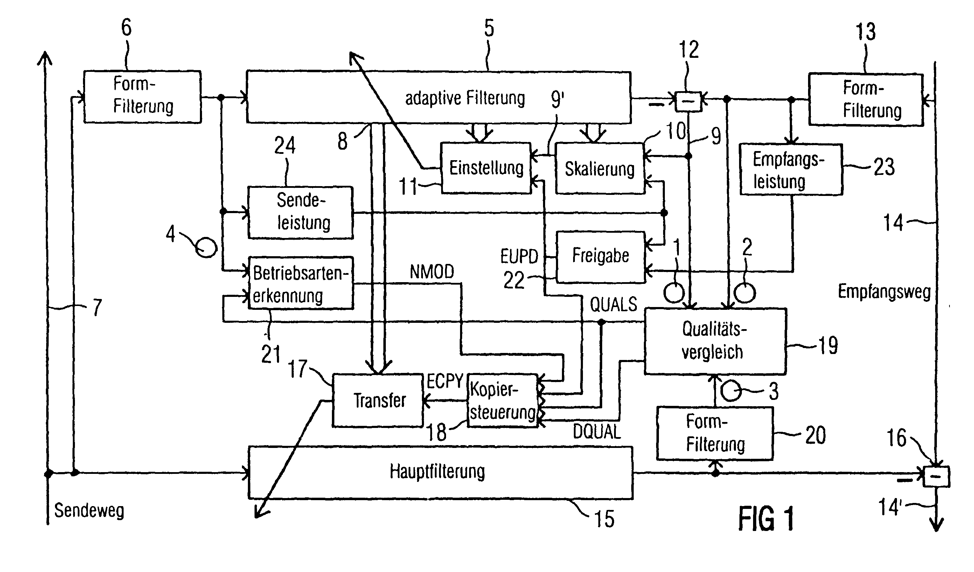

Das Ausführungsbeispiel nach Figur 1 enthält ein adaptives Filter 5, dessen Signaleingang unter Zwischenschaltung eines Formfilters 6 mit einem Sendeweg 7 gekoppelt ist und das einen Koeffizientenausgang 8 zur Ausgabe seiner Filterkoeffizienten aufweist. Zum Einstellen der Übertragungsfunktion des adaptiven Filters werden seine Koeffizienten dahingehend geändert, daß ein nach bestimmten Kriterien gebildetes Fehlersignal minimiert wird und daraus ein Ansteuersignal für das adaptive Filter bereitgestellt wird. Die Minimierung erfolgt bevorzugt nach dem Verfahren der kleinsten Fehlerquadrate. Dieses, auch LMS-Algorithmus genannte Verfahren ist beispielsweise aus D.Widrow, S.D.Stearns, Adaptive Signal Processing, Prentice-Hall INC., Engelwood Cliffs, New Jersey 1985, S. 99-140 und 288-295 bekannt. Die Minimierung des Fehlersignals 9 wird durch eine Skalierungseinrichtung 10 und eine dieser nachgeschalteten Einstellungsvorrichtung 11 gemäß dem LMS-Algorithmus durchgeführt. Der Skalierungseinrichtung 10 wird dazu das Fehlersignal 9 zugeführt und erhält darüber hinaus ebenso wie die Einstellungsvorrichtung 11 interne Signale des adaptiven Filters 5. Die Skalierungseinrichtung 10 erzeugt das minimierte Fehlersignal 9', anhand dessen die Einstellungsvorrichtung 11 die Koeffizienten des adaptiven Filters 5 optimal einstellt.

Das Fehlersignal 9 wird durch einen Subtrahierer 12 bereitgestellt, dessen invertierender Eingang mit dem Signalausgang des adaptiven Filters 5 und dessen nichtinvertierender Eingang bevorzugt unter Zwischenschaltung eines Formfilters 13 mit einem Empfangsweg 14 verbunden ist.

Weiterhin ist ein Hauptfilter 15 mit einem zum adaptiven Filter 5 identischen Übertragungsverhalten vorgesehen, dessen Eingang mit dem Sendeweg 7 verbunden ist und dessen Ausgang auf den invertierenden Eingang eines Subtrahierers 16 geführt ist. Der Subtrahierer 16 ist derart in den Empfangsweg 14 geschaltet, daß sein nichtinvertierender Eingang mit dem Empfangsweg 14 verschaltet ist und sein Ausgang den weiteren Empfangsweg 14' bildet. Das Hauptfilter 15 weist darüber hinaus einen Koeffizienteneingang auf, über den seine Übertragungsfunktion bestimmende Koeffizienten mittels einer Transfereinrichtung 17 geladen werden können. Die Transfereinrichtung 17 erhält dazu die Koeffizienten des adaptiven Filters 5, die an dem mit der Transfereinrichtung 17 gekoppelten Koeffizientenausgang 8 des adaptiven Filters 5 bereit stehen. Eine Übernahme der Koeffizienten des adaptiven Filters 5 in das Hauptfilter 15 erfolgt jedoch nur dann, wenn ein entsprechendes Kopiersignal ECPY an die Transfereinrichtung 17 angelegt wird.

Das Kopiersignal ECPY wird von einer Kopiersteuereinrichtung 18 in Abhängigkeit von an seinen Eingängen angelegten Signalen NMOD, EUPD, QUALS und DQUAL erzeugt. Das Qualitätssignal QUALS und das Qualitätsdifferenzsignal DQUAL wiederum werden von einer Qualitätsvergleichseinrichtung 19 bereitgestellt, deren erster Eingang 1 mit dem Ausgang des Subtrahierers 12, deren zweiter Eingang 2 mit dem Ausgang des Formfilters 13 und dessen dritter Eingang 3 unter Zwischenschaltung eines Formfilters 20 an den Ausgang des Hauptfilters 15 angeschlossen sind.

Das Qualitätssignal QUALS ist zudem auf einen Eingang einer Einrichtung zur Betriebsartenerkennung 21 geführt, deren anderer Eingang 4 an den Ausgang des Formfilters 6 angeschlossen ist und an deren Ausgang das Freigabesignal NMOD bereit steht. Das Freigabesignal EUPD das außer der Kopiersteuerung 18 auch der Einstellungsvorrichtung 11 zugeführt wird, wird durch eine Freigabeeinrichtung 22 erzeugt, deren einer Eingang mit einer Einrichtung 23 zum Ermitteln der Empfangsleistung und deren anderer Eingang mit dem Ausgang einer Einrichtung 24 zum Ermitteln der Sendeleistung verbunden ist. Die Einrichtung 23 zum Ermitteln der Empfangsleistung ist eingangsseitig mit dem Ausgang des Formfilters 13 verschaltet. Der Eingang der Einrichtung 24 zum Ermitteln der Sendeleistung, deren Ausgang zudem mit der Skalierungseinrichtung 10 gekoppelt ist, ist mit dem Ausgang des Formfilters 6 verbunden.

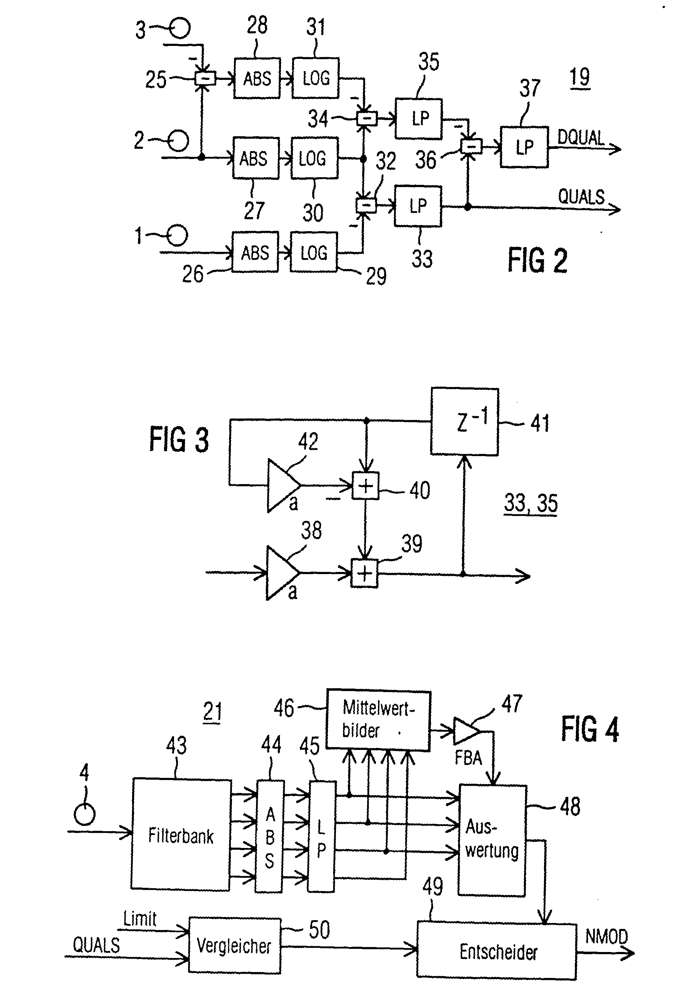

Die Qualitätsvergleichseinrichtung 19 nach Figur 1 wird bevorzugt gemäß dem in Figur 2 gezeigten Ausführungsbeispiel realisiert. Diese enthält einen Subtrahierer 25, dessen invertierender Eingang den Eingang 3 und dessen nichtinvertierender Eingang den Eingang 2 der Qualitätsvergleichseinrichtung 19 bildet. Der Eingang eines Absolutwertbilders 26 bildet den Eingang 1 der Qualitätsvergleichseinrichtung 19. Mit dem invertierenden Eingang und dem Ausgang des Subtrahierers 25 ist jeweils der Eingang eines Absolutwertbilders 27 bzw. 28 verbunden, deren Ausgänge ebenso wie der Ausgang des Absolutwertbilders 26 auf den Eingang jeweils eines Logarithmierers 29, 30 bzw. 31 geführt ist. An den Ausgang des Logarithmirers 29 ist der invertierende Eingang und an den Ausgang des Logarithmierers 30 ist der nichtinvertierende Eingang eines Subtrahierers 32 angeschlossen, dem ein Tiefpaßfilter 33 nachgeschaltet ist. In gleicher Weise ist der Ausgang des Logarithmierers 30 auf den nichtinvertierenden Eingang und der Ausgang des Logarithmierers 31 auf den invertierenden Eingang eines Subtrahierers 34 geführt, dem seinerseits ein Tiefpaßfilter 35 nachgeschaltet ist. Das Ausgangssignal QUAL des Tiefpasses 35 ist an den invertierenden Eingang eines Subtrahierers 36 gelegt, an dessen nichtinvertierenden Eingang das durch den Tiefpaß 33 bereitgestellte Qualitätssignal QUALS. Der Ausgang des Subtrahierers 36 erzeugt ein Qualitätsdifferenzsignal, das bevorzugt mittels eines Tiefpasses 37 tiefpaßgefiltert wird und das Qualitätsdifferenzsignal DQUAL bildet.

Eine bevorzugte Ausgestaltung der Tiefpässe 33 und 35 zeigt Figur 3. Ein Signal, das von dem Subtrahierer 32 bzw. 34 bereitgestellt wird, wird mittels einer Koeffizientenmultipliziereinrichtung 38 mit einem Koeffizienten a multipliziert und einem Addierer 39 zugeführt, der zudem das Ausgangssignal eines Subtrahierers 40 erhält. Das Ausgangssignal des Addierers 39 bildet das Ausgangssignal des Tiefpasses 33 bzw. 35, also das Qualitätssignal QUALS bzw. das Signal QUAL. An den Ausgang des Addierers 39 ist zudem ein Verzögerungselement 41 angeschlossen, dessen Ausgang mit dem nichtinvertierenden Eingang des Subtrahierers 40 direkt und mit dem invertierenden Eingang unter Zwischenschaltung einer Koeffizientenmultipliziereinrichtung 42 zur Multiplikation mit dem Koeffizienten a verbunden ist. Die Verwendung dieser Struktur ist nicht nur auf die Tiefpässe 33 und 35 beschränkt, sondern kann auch bei dem Tiefpaß 37 angewendet werden. Es wäre dann anstelle des Koeffizienten a ein davon verschiedener Koeffizient zu verwenden.

Die Betriebsartenerkennung 21 enthält gemäß Figur 4 bevorzugt eine Filterbank 43, der das Ausgangssignal des Formfilters 6 zugeführt wird und die beispielsweise vier frequenzspezifische Ausgangssignale abgibt. Die Ausgangssignale der Filterbank 43 werden zu einer Einrichtung zur Absolutwertbildung 44 geleitet, die eine der Zahl der Ausgangssignale entsprechende Anzahl von Absolutwertbilder enthält. Dieser ist wiederum eine Einheit zur Tiefpaßfilterung 45 mit der gleichen Anzahl von Tiefpässen nachgeschaltet. Die Ausgangssignale der Einheit zur Tiefpaßfilterung 45 sind an einen Mittelwertbilder 46 angelegt, der daraus ein Ausgangssignal erzeugt, das unter Zwischenschaltung einer Konstantenmultipliziereinrichtung 47 zur Multiplikation mit einer konstanten FBA einer Auswerteeinrichtung 48 zugeführt wird. An die Auswerteeinrichtung 48 sind zudem drei der vier Ausgangssignale der Einrichtung zur Tiefpaßfilterung 45 angelegt. Ein Eingang eines Entscheiders 49 ist an den Ausgang der Auswerteeinrichtung 48 angeschlossen. Sein anderer Eingang ist mit dem Ausgang eines Vergleichers 50 gekoppelt, an dessen einen Eingang das Qualitätssignal QUALS und ein Vergleichswert Limit angelegt sind. Am Ausgang des Entscheiders 49 wird das Freigabesignal NMODE bereitgestellt.

Die erfindungsgemäßen adaptiven Balancefilter gemäß den oben gezeigten Ausführungsbeispielen sind als Mikroprogramm in einem Signalprozessor implementiert. Es kann daneben aber auch bei allen anderen Arten von Datenverarbeitungseinrichtungen wie beispielsweise Mikrocontrollern, Mikrocomputern, Mikroprozessoren usw. installiert werden und daneben ganz oder teilweise in Hardware ausgeführt werden. Bei Software-Ausführungen stellen die einzelnen Funktionsblöcke einzelne Programmteile dar, während sie bei Hardware-Ausführungen fest verdrahtete Schaltungsteile wiedergeben.

Nachdem zuvor der prinzipielle Aufbau eines erfindungsgemäßen Balancefilters erläutert worden ist, wird nachfolgend näher auf die Funtionsweise des Balancefilters eingegangen.

Bei dem erfindungsgemäßen adaptiven Balancefilter wird davon ausgegangen, daß das adaptive Filter 5 weitgehend seine Koeffizienten immer nachregelt. In dem Fall, daß nur einer der Fernsprechteilnehmer (A-Teilnehmer) spricht, wird die Echodämpfung des adaptiven Filters 5 größer werden als die Echodämpfung des Hauptfilters 15. In diesem Fall werden die Koeffizienten des adaptiven Filters 5 in das Hauptfilter 15 kopiert. Im Falle des gleichzeitigen Sprechens beider Teilnehmer wird aufgrund der weiterhin stattfindenden Nachregelung der Koeffizienten des adaptiven Filters 5 die Echodämpfung des adaptiven Filters 5 zurückgehen, da das Signal des anderen Teilnehmers (B-Teilnehmer) die Nachregelung verfälscht. Daher ist die Echodämpfung des adaptiven Filters 5 schlechter als die Echodämpfung des Hauptfilters 15. In dem Fall werden die Koeffizienten nicht kopiert.

Die Koeffizienten des adaptiven Filters 5 werden immer dann kopiert, wenn seine Echodämpfung besser ist als die Echodämpfung des Hauptfilters 15. Dies hat zur Folge, daß auch während gleichzeitig gesprochen wird ein Kopiervorgang stattfinden kann. Beispielsweise direkt nach Aktivierung des Balancefilters sind alle Koeffizienten auf Null zurückgesetzt. Die Echodämpfung sowohl des adaptiven Filters 5 als auch des Hauptfilters 15 ist gleich Null. Das adaptive Filter wird durch die Nachregelung seiner Koeffizienten zwar nicht die maximal mögliche, doch zumindest eine gewisse Echodämpfung erzielen. Die Echodämpfung des Hauptfilters 15 bleibt dagegen auf Null. Damit ist die Bedingung für ein Kopieren der Koeffizienten erfüllt.

Um zu verhindern, daß die Koeffizienten des adaptiven Filters 5 sich total falsch einstellen, wird die Nachregelung der Koeffizienten des adaptiven Filters 5 durch einen einfachen Vergleich der mittleren Energien von Sende- und Empfangssignal freigegeben bzw. gestoppt. Eine Fehleinstellung könnte sich beispielsweise dann ergeben, wenn nur der B-Teilnehmer spricht.

Die Einrichtungen 24, 23 zur Ermittlung der Sende- und Empfangsleistungen mitteln die Leistungen der Signale auf Sende- und Empfangsweg 7, 14. Die Freigabeinrichtung 22 wertet die gemittelten Leistungen aus und steuert die Nachregelung der Koeffizienten des adaptiven Filters 5. Damit die Koeffizienten durch den LMS-Algorithmus nachgeregelt werden, müssen zwei Bedingungen erfüllt sein. Zum einen muß die Sendeleistung einen einstellbaren ersten Wert und zum anderen muß die Differenz zwischen Sendeleistung und Empfangsleistung einen bestimmten einstellbaren zweiten Wert überschreiten. Der zweite Wert sollte so eingestellt werden, daß bei offener Leitung noch geregelt wird. Sobald der B-Teilnehmer spricht, wird die Nachregelung gestoppt. Bei diesem Betriebsfall arbeitet die Steuerung ideal. Während einer zustandegekommenen Verbindung ist die Gabelübergangsdämpfung aber wesentlich größer und damit das rückgekoppelte Sendesignal erheblich kleiner als bei einer offenen Leitung. In diesem Fall ist der eingestellte Schwellwert für die Differenz von Sendeleistung zu Empfangsleistung jedoch deutlich zu klein. Um hierbei die Nachregelung stoppen zu können, müßte der B-Teilnehmer deutlich lauter als der A-Teilnehmer sein. Damit kann aber lediglich eine vollständige Verstellung des adaptiven Filters 5 verhindert werden. Das adaptive Filter 5 ist also bei gleichzeitigem Sprechen beider Teilnehmer nicht ideal eingestellt und die Koeffizienten sollten in diesem Fall nicht kopiert werden.

Eine Folge des kontrollierten Kopierens der Koeffizienten ist allerdings, daß eine gewisse Reaktionszeit gegeben ist, da erst sichergestellt sein muß, daß die Einstellung des adaptiven Filters 5 besser ist als die Einstellung des Hauptfilters 15, bevor die Koeffizienten kopiert werden. Eine Reaktionszeit von 20 bis 80 msec ist für das menschliche Gehör kaum wahrnehmbar und daher akzeptabel. Beispielsweise bei den Abnahmemessungen der deutschen Bundespost werden jedoch einige Messungen mit einem frequenzmäßig schnell durchlaufenden Sinuston durchgeführt. Hierbei macht sich die Reaktionszeit negativ bemerkbar, da die Messungen immer nur dann optimal sind, wenn die Koeffizienten gerade kopiert wurden. Um den Nachteil der Reaktionszeit während der Abnahmemessung zu beseitigen, werden in der Kopiersteuereinrichtung 18 zwei Betriebsarten unterschieden, wobei die Identifizierung der beiden Betriebsarten durch die Einrichtung zur Erkennung der Betriebsarten 21 vorgenommen wird. Auf deren Funktionsweise wird später noch im einzelnen eingegangen.

Wesentlich für die Funktionsweise des erfindungsgemäßen adaptiven Balancefilters ist, daß die Koeffizienten nur dann kopiert werden, wenn die Echodämpfung des adaptiven Filters 5 besser ist, als die des Hauptfilters 15. Da für die Entscheidung, wann die Koeffizienten kopiert werden sollen, lediglich ein Vergleich der beiden Echodämpfungen notwendig ist, muß der absolute Wert der jeweiligen Echodämpfung nicht bekannt sein.

Das Signal des B-Teilnehmers ist am nichtinvertierenden Eingang und am Ausgang des Subtrahierers 16 identisch, da das Hauptfilter 15 den B-Teilnehmer nicht kompensieren kann. Das Echosignal des A-Teilnehmers kommt in dem Signal am Ausgang des Subtrahierers 16 nur noch reduziert vor. Ein durch einen Vergleich der Signale am nichtinvertierenden Eingang und am Ausgang des Subtrahierers 16 gewonnenes Signal entspricht daher nur dann der absoluten Echodämpfung des adaptiven Balancefilters, wenn der B-Teilnehmer nicht spricht. Während eines Gesprächs ist dieser Wert lediglich ein Maß für die Dämpfungsqualität des adaptiven Balancefilters.

Für die Beurteilung der Dämpfungsqualität des adaptiven Balancefilters werden die Signale am nichtinvertierenden Eingang und am Ausgang des Subtrahierers 12 herangezogen. Diese beiden Signale werden direkt der Qualitätsvergleichseinrichtung 19 zugeführt. Die entsprechenden Signale für das Hauptfilter 15 sind jedoch noch zu ermitteln. Um einen wirkungsvollen Vergleich zwischen adaptivem Filter 5 und Hauptfilter 15 zu ermöglichen, wird bevorzugt das Ausgangssignal des Hauptfilters 15 über das Formfilter 20 zu der Qualitätsvergleichseinrichtung 19 geleitet. Das Ausgangssignal des Formfilters 20 wird innerhalb der Qualitätsvergleichseinrichtung 19 von dem am Eingang 2 anliegenden Ausgangssignal des Formfilters 13 subtrahiert. Das durch die Subtraktion gewonnene Signal stellt das normierte Fehlersignal des Hauptfilters 15 dar. Das am Eingang 1 anliegende Signal dagegen bildet das Fehlersignal 9 des adaptiven Filters 5.

Als Kriterium für die Dämpfungsqualität von adaptivem Filter 5 und Hauptfilter 15 wird von dem am Eingang 2 anliegenden Fehlersignal 9 des adaptiven Filters 5 und dem normierten Fehlersignal des Schattenfilters 15 zuerst der Absolutwert und davon wiederum der Logarithmus gebildet. Das logarithmierte Fehlersignal des adaptiven Filters 5 wird von dem logarithmierten Ausgangssignal des Formfilters 13 abgezogen und durch den Tiefpaß 35 gemittelt. Das logarithmierte, normierte Fehlersignal des Hauptfilters 15 wird von dem logarithmierten Ausgangssignal des Formfilters 13 abgezogen und durch den Tiefpaß 33 ebenfalls gemittelt. Das Ausgangssignal QUAL des Tiefpasses 35 ist ein Maß für die Dämpfungsqualität des Hauptfilters 15. Das Ausgangssignal QUALS ist ein Maß für die Qualität des adaptiven Filters 5 und wird daher als Qualitätssignal QUALS bezeichnet. Um optimale Vergleichsergebnisse zu erzielen, werden die Zeitkonstanten der beiden Tiefpässe 33 und 35 bevorzugt identisch gewählt. Als übliche Werte kommen beispielsweise Zeitkonstanten zwischen 20 msec und 50 msec in Frage. Bei kleineren Zeitkonstanten wird eine Veränderung der Qualität zwar schneller erkannt, doch ist die Mittelung mit einem größeren Fehler behaftet. Bei größeren Zeitkonstanten ist die Mittelung genauer, dafür reagiert aber die Qualitätsbestimmung träger.

Um zu entscheiden, welches der beiden Filter -adaptives Filter 5 und Hauptfilter 15- besser eingestellt ist, wird das Signal QUAL, das für die Qualität des Hauptfilters 15 steht, von dem Qualitätssignal QUALS, das für die Qualität des adaptiven Filters 5 steht, subtrahiert. Das so erhaltene Signal wird bevorzugt tiefpaßgefiltert. Das Ausgangssignal DQUAL des Tiefpasses 37 charakterisiert somit die Qualitätsdifferenz zwischen adaptivem Filter 5 und Hauptfilter 15. Bei positivem Qualitätsdiffernzsignal DQUAL ist das adaptive Filter 5 besser eingestellt als das Hauptfilter 15. Die Zeitkonstante des Tiefpasses 37 kann beispielsweise Werte zwischen 10 msec und 40 msec annehmen. Auf die Mittelung des Ausgangssignals des Subtrahierers 36 kann verzichtet werden, wenn für die beiden Tiefpässe 33 und 35 bereits eine größere Zeitkostante gewählt wurde.

In dem Fall, daß nur der A-Teilnehmer spricht, ist das Qualitätssignal QUALS ein Maß für die Echodämpfung des adaptiven Filters 5. Aus dem Qualitätsdifferenzsignal DQUAL kann abgeleitet werden, welcher der beiden Filter -adaptives Filter 5 und Hauptfilter 15- besser eingestellt ist. Fällt der B-Teilnehmer dem A-Teilnehmer ins Wort, dann wird sowohl das Qualitätssignal QUALS als auch das Qualitätsdifferenzsignal DQUAL kleiner werden, da die Echodämpfung prozentual zu der Leistung des Signals auf dem Empfangsweg 14 kleiner wird. Zusätzlich wird sich die Echodämpfung des adaptiven Filters 5 aufgrund des Einflusses des Signals vom B-Teilnehmer auf die Nachregelung der Koeffizienten verschlechtern und somit die Signal QUALS und DQUAL weiter reduziert. Beide Effekte verhindern, daß die Koeffizienten des adaptvien Filters 5 versehentlich während des gleichzeitigen Sprechens beider Teilnehmer kopiert werden. Beide Effekte ermöglichen daher ein stabiles Arbeiten der Kopiersteuereinrichtung 18. Sind die Koeffizienten des adaptiven Filters 5 verstellt, wie beispielsweise nach dem erstmaligen Einschalten des adaptiven Balancefilters, so kann es durchaus sein, daß das Qualitätsdifferenzsignal DQUAL so groß wird, daß die Koeffizienten trotz des gleichzeitigen Sprechens kopiert werden. Aufgrund der beiden eben beschriebenen Effekte ist aber sichergestellt, daß das adaptive Filter 5 auf jeden Fall eine bessere Einstellung besitzt als das Hauptfilter 15.

Beispielsweise bei Implementierung des Balancefilters in einen digitalen Signalprozessor liegen die Signale als Binärzahlen vor und die innerhalb der Qualitätsvergleichseinrichtung 19 benötigte Logarithmierung kann mit sehr einfachen Mitteln durchgeführt werden. Einen angenäherten Logarithmus zur Basis 2 erhält man beispielsweise mittels einer Normierungseinheit. Es wird dabei lediglich die Stelle der führenden 1 (Exponent) und die niederwertigeren Bits nach der führenden 1 (Mantisse) benötigt. Fügt man die Binärzahl des Exponenten vor die Binärzahl der Mantisse, so erhält man einen angenäherten Logarithmus. Um auszuschließen, daß eventuelle Rechenungenauigkeiten der hinteren Bits der an die Logarithmusbilder 29, 30, 31 angelegten Eingangsworte die Ausgangssignale der Qualitätsvergleichseinrichtung 19 beeinflussen, kann der Logarithmusbilder mit einer programmierbaren Schwelle versehen werden. Dazu werden von dem Eingangs- oder Ausgangssignal des jeweiligen Logarithmusbilders ein programmierbarer fester Wert subtrahiert. Ist das Ergebnis negativ, wird das Ergebnis der Subtraktion auf Null gesetzt.

Eine einfache Realisierung der Tiefpässe 33 und 35 und gegebenenfalls des Tiefpasses 37 auf einem digitalen Signalprozessor zeigt das Ausführungsbeispiel nach Figur 3. Das um einen Abtasttakt verzögerte Ausgangssignal des jeweiligen Tiefpasses wird mit einem Koeffizienten a multipliziert. Das Ergebnis dieser Multiplikation wird von dem um einen Takt verzögerten Ausgangssignal subtrahiert und zu diesem Wert das mit dem Koeffizienten a multiplizierte Eingangssignal des jeweiligen Tiefpasses addiert. Der durch die Addition erhaltene Wert ist der neue Ausgangswert des Tiefpasses. Der Koeffizient a bestimmt die Zeitkonstante $\tau$ des Tiefpasses. Dabei gilt folgender Zusammenhang zwischen der Zeitkonstante $\tau$ und dem Koeffizienten a sowie der Zeit T zwischen zwei Abtastwerten:

$$\tau = \frac{T}{\ln(1 - a)}$$

Je nach gewählter Zeitkonstante kann der Koeffizient a durch eine einfache Schiebeoperation nach rechts ersetzt werden. Dies ist immer dann der Fall, wenn für den Koeffizienten a folgende Werte gewählt werden:

$$a = \frac{1}{2^n} \quad n = 1, 2, 3....$$

Bedingt durch die Zeitkonstanten der Tiefpässe 33 und 35 und gegebenenfalls des Tiefpasses 37 tritt zwischen der Änderung der Echodämpfung und der vollständigen Nachregelung der Signale QUALS und DQUAL eine endliche Verzögerungszeit auf. Dadurch ist es möglich, daß die Koeffizienten des adaptiven Filters 5 erst dann kopiert werden, wenn das adaptive Filter 5 eine gewisse Zeit eine bessere Echodämpfung erzielt hat als das Hauptfilter 15. Dies ist auch gewollt, daß erst sicher sein soll, daß Koeffizienten des adaptiven Filters 5 besser sind, als die des Hauptfilters 15, bevor ein Kopiervorgang eingeleitet wird. Im praktischen Betrieb des adaptiven Balancefilters wird die Verzögerungszeit kaum bemerkt und daher nicht als störend empfunden.

Beispielsweise bei den Abnahmemessungen der Deutschen Bundespost, bei der ein frequenzmäßig schnell durchlaufender Sinuston eingespeist wird, adaptiert das adaptive Filter 5 seine Koeffizienten an jede der Frequenzen verhältnismäßig schnell. Aufgrund der geringen Frequenzinformation des Sinussignals ist die Echodämpfung des adaptiven Filters 5 jedoch nur für die jeweils anliegende Frequenz des Sinustons optimal eingestellt. Die Echodämpfung für alle anderen Frequenzen ist undefiniert. Da aber die Koeffizienten durch die Verzögerungszeit immer nur dann kopiert werden, wenn das adaptive Filter 5 für eine gewisse Zeit eine bessere Echodämpfung besitzt als das Hauptfilter 15, wird die Echodämpfung des Hauptfilters 15 immer nur unmittelbar nach einem Kopiervorgang optimal sein.

Um diese Problematik zu umgehen, wurden zwei unterschiedliche Betriebsarten definiert. Unmittelbar nach dem Einschalten des adaptiven Balancefilters ist das Freigabesignal NMODE gleich Null. In diesem Fall wird die Kopiersteuereinrichtung 18 angewiesen, die Koeffizienten ständig zu kopieren. Dadurch erhält das Hauptfilter 15 ständig die aktuellen Koeffizienten des adaptiven Filters 5 und kann folglich den Sinus kompensieren. Erst nachdem die Einrichtung zur Betriebsartenerkennung 21 Sprache detektiert hat, wird das Freigabesignal NMODE gleich 1 gesetzt und damit in die normale Betriebsart gewechselt. Nur bei der normalen Betriebsart werden die Signale QUALS und DQUAL von der Kopiersteuereinrichtung ausgewertet. Das durch das Kopiersignal ECPY eingeleitete Kopieren der Koeffizienten ist abhängig von dem Vergleich der Dämpfungsqualitäten von adaptivem Filter 5 und Hauptfilter 15.

Die Einrichtung zur Betriebsartenerkennung 21 erhält gemäß Figur 4 bevorzugt die Filterbank 43, die das Ausgangssignal des Formfilters 6 beispielsweise in vier, jeweils einem Frequenzband zugeordnete Signale zerlegt. Die Durchlaßbereiche der vier Bandpässe überschneiden sich bevorzugt nicht. Die Wahl der Steilheit und der Bandbreite der einzelnen Bandpässe ist relativ unkritisch, da ein Sinussignal maximal in zwei benachbarten Frequenzbändern erscheinen kann. Von den vier Ausgangssignalen der Filterbank 43 wird jeweils der Absolutwert gebildet und anschließend mit Hilfe der Tiefpässe 45 gemittelt. Bei Bedarf kann auch zwischen die Tiefpässe 45 und die Absolutwertbilder 44 für jedes der einzelnen Signale ein Logarithmierer vorgesehen werden.

Die Signale an den Ausgängen der Tiefpässe 45 werden dem Mittelwertbilder 46 zugeführt, der den Mittelwert der vier Signale berechnet. Der Mittelwert wird anschließend mit dem Faktor FBA multipliziert, der einstellbar ist und kleiner als 1 sein muß. Das Ergebnis der Multiplikation ist ein Vergleichswert für die Auswerteeinrichtung 48. Die Auswerteeinheit 48 vergleicht die gemittelten Werte der untersten drei Frequenzbänder mit dem Vergleichswert. Das Ausgangssignal der Auswerteeinheit 48 geht genau dann auf 1, wenn alle drei gemittelten Werte der unteren drei Frequenzbänder über dem Vergleichswert liegen. Dann nämlich besitzt das Spektrum des Signals am Eingang des adaptiven Filters 5 in den untersten drei Frequenzbändern wesentliche Anteile. Da bei Sprache in der Regel hauptsächlich Frequenzen unterhalb von 3000 Hz vorkommen, kann auf die Auswertung des oberen Frequenzbereiches, der vorzugsweise über 3000 Hz liegt, verzichtet werden.

Für das Umschalten in die normale Betriebsart ist nicht nur ein entsprechendes Frequenzspektrum erforderlich, sondern auch eine gewisse Echodämpfung des adaptiven Filters 5. Durch den Vergleich des Qualitätssignals QUALS, das ein Maß für die Echodämpfung des adaptiven Filters 5 ist, mit einem frei einstellbaren Mindestwert, wird entschieden, ob die geforderte Echodämpfung erreicht worden ist. Ist das Qualitätssignal QUALS größer als der einstellbare Wert Limit, so geht das Ausgangssignal der Vergleichseinrichtung 50 auf 1. Andernfalls geht das Ausgangssignal auf Null. Der Entscheider 49 bestimmt anhand der Ausgangssignale von Vergleichseinrichtung 50 und Auswerteeinrichtung 48, wann in die normale Betriebsart übergegangen wird. Das Freigabesignal NMODE geht genau dann auf 1 und signalisiert damit die normale Betriebsart, wenn das Ausgangssignal der Auswerteeinheit 48 und das Ausgangssignal des Vergleichers 50 für eine einstellbare Zeitspanne gleichzeitig und konstant gleich 1 sind. Das Spektrum des am Eingang des adaptiven Filters 5 anliegenden Signals als auch die Echodämpfung des adaptiven Filters 5 sind dann für die bestimmte Zeit besser als gefordert.

Nachdem einmal in die normale Betriebsart gewechselt worden ist, bleibt das adaptive Balancefilter so lange in der normalen Betriebsart, bis es wieder zurückgesetzt wird.

Ist das Freigabesignal NMOD gleich Null und befindet sich damit das adaptive Balancefilter noch nicht in der normalen Betriebsart, so werden die Koeffizienten des adaptiven Filters 5 ständig in das Hauptfilter 15 kopiert. Erst wenn das Freigabesignal NMOD gleich 1 ist, wird das Kopieren der Koeffizienten gezielt gesteuert.

Stoppt die Freigabeeinrichtung 22 die Nachregelung der Koeffizienten des adaptiven Filters 5 durch Rücksetzen des Freigabesignals EUPD auf Null, indem es das beiderseitige Sprechen erkannt hat, so wird das Kopieren der Koeffizienten in jedem Fall unterbunden. In dem Fall, daß beiderseitiges Sprechen erkannt wurde, muß davon ausgegangen werden, daß das adaptive Filter 5 durch den B-Teilnehmer aus seinem bisherigen Optimum weggeregelt wurde. Ein Kopieren der Koeffizienten ist daher nicht sinnvoll.

Damit bei dem erstmaligen Einregeln des adaptiven Balancefilters die Regelgeschwindigkeit nicht durch die Zeitkonstanten der Tiefpässe in der Qualitätvergleichseinrichtung 19, also den Tiefpässen 33, 35 und 37, bestimmt wird, wird die Dämpfungsqualität QUALS des adaptiven Filters 5 mit seinem bisher erreichten Maximalwert verglichen. Ist die aktuelle Dämpfungsqualität QUALS des adaptiven Filters 5 größer als der bisherige Maximalwert, werden die Koeffizienten kopiert. Dadurch bestimmt nur die Zeitkonstante des Tiefpasses 33 das Einschwingverhalten, nicht aber die Zeitkonstante des Tiefpasses 37.

Da eine große Echodämpfung vor allem bei Signalen, bei denen das Frequenzspektrum aus wenigen Frequenzanteilen besteht, erreicht wird, muß verhindert werden, daß nach Erreichen einer sehr großen Echodämpfung die Koeffizienten praktisch nicht mehr kopiert werden können. Dies wird dadurch realisiert, daß das Qualitätsdifferenzsignal DQUAL mit einem einstellbaren Wert verglichen wird. Ist das Qualitätsdifferenzsignal DQUAL größer als der eingestellte Wert des Parameters DELQ, werden die Koeffizienten kopiert. Der Parameter DELQ nimmt beispielsweise einen Wert an, der einer Echodämpfung von ca. 3dB entspricht. Ein derartiger Vergleich ist auch nötig, wenn sich die Leitungsimpedanz ändert und im weiteren nur eine schlechtere Echodämpfung erzielt werden kann. Da der Maximalwert automatisch bei einem Kopiervorgang auf den aktuellen Qualitätswert des adaptiven Filters 5 gesetzt wird, ist gewährleistet, daß im Falle, daß nach einem Kopiervorgang die Echodämpfung des adaptiven Filters 5 sich weiter erhöht, die Koeffizienten des Schattenfilters 15 und damit des gesamten adaptiven Balancefilters sofort nachgeregelt werden. Wenn sich beispielsweise während eines Gesprächs die Impedanz der Leitung ändert, wird der aufgrund der Änderung des Echopfades folgende Kopiervorgang aufgrund Vergleichs des Qualitätsdifferenzsignals DQUAL mit einem fest vorgegebenen Parameter DELQ eingeleitet, wobei das Qualitätsdifferenzsignal DQUAL größer sein muß als der Parameter DELQ.

Durch das Gleichsetzen des Maximalwertes QMAXS mit dem Qualitätssignal QUALS werden die weiteren Kopiervorgänge durch den Vergleich des Qualitätssignals QUALS mit dem Maximalwert QMAXS angestoßen. Die Zeitkonstante des Tiefpasses 37 geht für das Qualitätsdifferenzsignal DQUAL geht im folgenden nicht mehr in die Einregelgeschwindigkeit des Hauptfilters 15 mit ein. Wenn die Hauptdämpfung des Schattenfilters 15 genauso groß werden soll wie die Echodämpfung des adaptiven Filters 5, muß eine weitere Bedingung für das Kopieren der Koeffizienten vorgesehen werden. Eine weitere Bedingung für das Kopieren der Koeffizienten ist, daß das Qualitätsdifferenzsignal DQUAL größer als Null ist, daß heißt, daß das adaptive Filter 5 besser eingestellt ist als das Hauptfilter 15. Da bei gleichzeitigem Sprechen beider Teilnehmer die Werte für die Signale QUALS und QUAL gegen Null gehen, muß für einen Kopiervorgang nicht nur das Qualitätsdifferenzsignal DQUAL größer Null sein, sondern es muß auch zusätzlich das Qualitätssignal QUALS größer als der einstellbare Wert Limit sein. Das bedeutet, daß die Qualität des adaptiven Filters 5 einen Mindestwert überschreiten muß. Um die Sicherheit der Kopierentscheidung zu erhöhen, müssen die obengenannten beiden Bedingungen für eine vorgegebene Zeit erfüllt sein, damit die Koeffizienten aufgrund dieser Bedingungen kopiert werden. Damit die vorgegebene Zeitspanne ihrem Zweck in jeden Fall erfüllen kann, muß sie jedesmal zurückgesetzt werden, sobald festgestellt wird, daß die Koeffizienten kopiert bzw. nicht kopiert werden dürfen.

Es ist empfehlenswert, jedoch nicht unbedingt erforderlich, nachdem ein Kopiervorgang veranlaßt worden ist, das Signal QUAL und dementsprechend die interne Speicherzelle des zugehörigen Tiefpasses 35 auf den Wert des Qualitätssignals QUALS zu setzen. Dadurch wird erreicht, daß direkt nach einem Kopiervorgang nur bei Vorliegen der Bedingung, daß das Qualitätssignal QUALS größer ist als der Maximalwert QMAX, ein erneuter Kopiervorgang veranlaßt werden kann. Denn hierbei können sich die Werte für die Signale QUAL, QUALS und DQUAL nur mit den eingestellten Zeitkonstanten verändern. Dies bedeutet, daß unmittelbar nach einem Kopiervorgang die Bedingung DQUAL > DELQ weiterhin erfüllt sein kann. Dies wird durch das Gleichsetzen der Signale QUAL und QUALS verhindert. Das Signal DQUAL muß daher nach einem Kopiervorgang kleiner werden. Aus den eben angegebenen Gründen könnte das Qualitätsdifferenzsignal DQUAL während eines Kopiervorgangs ebenfalls auf Null gesetzt werden.

Der Funktionsablauf innerhalb der Kopiersteuereinrichtung 18 ist nachfolgend anhand eines C-Programms im einzelnen dargestellt. Neben den bereits erläuterten Signalen und Variablen werden darüber hinaus eine Zählervariable zur Generierung der Zeitspanne mit ZTIMQ, sowie einstellbare Parameter für den Grenzwert Limit, für den Mindestwert des Qualitätsdifferenzsignals DQUAL und für die Zeitdauer der Zeitspanne als LIMQ, DELQ bzw. TIMQ bezeichnet. Das Programm lautet:

```
if (!NMOD)  {ZTIMQ=0;  ECPY=TRUE;  QUAL=QMAXS=QUALS;}
else
 if (!EUPD)  {ZTIMQ=0;  ECPY=FALSE;}
 else
  if (QUALS>QMAXS)  {ZTIMQ=0;  ECPY=TRUE;  QUAL=QMAXS=QUALS;}
  else
   if (DQUAL>DELQ)  {ZTIMQ=0;  ECPY=TRUE;  QUAL=QMAXS=QUALS;}
   else
    if (DQUAL>0) && (QUALS>LIMQ) {
      if (ZTIMQ>TIMQ) {ZTIMQ=0;  ECPY=TRUE;
        QUAL=QMAXS=QUALS;}
       else {ZTIMQ++;  ECPY=FALSE;}
    } else {ZTIMQ=0;  ECPY=FALSE;}
```

**Patentansprüche**

**1.** Adaptives Balancefilter

mit einem adaptiven Filter (5), das einen Signalausgang einen Koeffizientenausgang zur Ausgabe seiner Filterkoeffizienten, einen Fehlersignaleingang sowie einen mit einem Sendeweg (7) gekoppelten Signaleingang aufweist,

mit einem Hauptfilter (15), das einen Signalausgang, einen mit dem Sendeweg (7) gekoppelten Signaleingang sowie einen Koeffizienteneingang zum Laden von Filterkoeffizienten aufweist, mit einem ersten Subtrahierer (16), dessen einer Eingang mit einem Empfangsweg (14) und dessen anderer Eingang mit dem Ausgang des Hauptfilters (15) gekoppelt ist und dessen Ausgang den weiteren Verlauf (14') des Empfangswegs (14) bildet, mit einem zweiten Subtrahierer (12), dessen einer Eingang mit dem Empfangsweg (14), dessen anderer Eingang mit dem Signalausgang des adaptiven Filters (5) und dessen Ausgang mit dem Fehlersignaleingang des adaptiven Filters (5) gekoppelt ist, mit einer Transfereinrichtung (17), die zwischen den Koeffizientenausgang des adaptiven Filters (5) und den Koeffizienteneingang des Hauptfilters (15) geschaltet ist und die einen Steuereingang für das Laden der Filterkoeffizienten des adaptiven Filters (5) in das Hauptfilter (15) bei Auftreten eines entsprechenden Kopiersignals (ECPY) aufweist und mit einer Transfersteuereinrichtung (18, 19),

**dadurch gekennzeichnet,**

daß die Transfersteuereinrichtung (18, 19) drei Eingänge (1, 2, 3) aufweist, von denen der erste (1) mit dem Ausgang des zweiten Subtrahierers (12), der zweite (2) mit dem einen Eingang des zweiten Subtrahierers (12) und der dritte mit dem Ausgang des Hauptfilters (15) gekoppelt ist,

daß die Transfersteuereinrichtung (18, 19) aus den an den drei Eingängen (1, 2, 3) anliegenden Signalen die Echodämpfungen von adaptivem Filter (5) und Hauptfilter (15) ermittelt, die beiden Echodämpfungen miteinander vergleicht und im Falle einer gegenüber dem Hauptfilter (15) höheren Echodämpfung des adaptiven Filters (5) der Transfereinrichtung (17) ein entsprechendes Kopiersignal zuführt.

2. Balancefilter nach Anspruch 1,
   **gekennzeichnet durch**

   ein erstes Formfilter (13), das zwischen den einen Eingang des zweiten Subtrahierers (12) und den Empfangsweg (14) geschaltet ist,
   durch ein zweites Formfilter (6), das ein zum ersten Formfilter (13) identisches Übertragungsverhalten hat und daß zwischen dem Sendeweg (7) und dem Signaleingang des adaptiven Filters (5) geschaltet ist und durch ein drittes Formfilter (20), das ein zum ersten Formfilter (13) identisches Übertragungsverhalten aufweist und daß zwischen den Ausgang des Hauptfilters (15) und den dritten Eingang (3) der Transfersteuereinrichtung geschaltet ist.

3. Balancefilter nach Anspruch 1 oder 2, **dadurch gekennzeichnet**, daß die

   Transfersteuereinrichtung (18, 19) eine Qualitätsvergleichseinrichtung (19) enthält,
   mit einem dritten Subtrahierer (25), dessen einer Eingang den zweiten Eingang (2) und dessen anderer Eingang den dritten Eingang (3) der Transfersteuereinrichtung bildet,
   mit einem ersten Absolutwertbilder (26), dessen Eingang den ersten Eingang (1) der Transfersteuereinrichtung (18, 19) bildet, mit einem zweiten Absolutwertbilder (27), dessen Eingang mit dem einen Eingang des dritten Subtrahierers (25) verbunden ist,
   mit einem dritten Absolutwertbilder (28), der dem dritten Subtrahierer (25) nachgeschaltet ist,
   mit einem ersten, zweiten und dritten Logarithmierer (29, 30, 31), die jeweils erstem, zweitem und drittem Absolutwertbilder (26, 27, 28) nachgeschaltet sind,
   mit einem vierten Subtrahierer (32), dessen Eingänge jeweils mit den Ausgängen von erstem bzw. zweitem Logarithmierer (29, 30) verbunden sind,
   mit einem fünften Subtrahierer (34), dessen Eingänge jeweils mit den Ausgängen von zweitem bzw. drittem Logarithmierer (30, 31) verbunden sind,
   mit einem ersten und zweiten Tiefpaß (33, 35), die jeweils vierten bzw. fünften Subtrahierer (32, 34) nachgeschaltet sind,
   mit einem Subtrahierer (36), dessen Eingänge mit den Ausgängen von erstem und zweitem Tiefpaß (33, 35) verbunden sind, und daß die Transfersteuereinrichtung eine Kopiersteuereinrichtung (18) enthält, deren Eingang mit dem Ausgang des sechsten Subtrahierers (36) gekoppelt ist, die das von dem sechsten Subtrahierer (36) bereitgestellte Qualitätsdifferenzsignal (DQUAL) mit einem ersten Vergleichswert vergleicht und bei Abweichung beider voneinander in eine bestimmte Richtung ein Kopiersignal (ECPY) für die Transfereinrichtung (17) erzeugt, wobei der erste Vergleichswert dann gleich dem aktuellen Wert des Qualitätsdifferenzsignals (DQUAL) gesetzt wird.

4. Balancefilter nach Anspruch 3,
   **dadurch gekennzeichnet,**
   daß dem sechsten Subtrahierer (36) ein dritter Tiefpaß (37) nachgeschaltet ist.

5. Balancefilter nach einem der Ansprüche 1 bis 4,
   **dadurch gekennzeichnet,**

   daß die Transfersteuereinrichtung (18, 19, 22, 23, 24), Einrichtungen (24, 23) zum Ermitteln der Leistungen des am Eingang des adaptiven Filters (5) anliegenden Sendesignals und des am einen Eingang des zweiten Subtrahierers (12) anliegenden Empfangssignals sowie
   eine den beiden Einrichtungen (23, 24) zum Ermitteln der Sende- und Empfangsleistung nachgeschaltete Freigabeeinrichtung (22), die dann ein Freigabesignal (EUPD) an die Kopiersteuereinrichtung (18) zur Freigabe des Kopiersignals (ECPY) abgibt, wenn das Sendeleistungssignal einen ersten Referenzwert und die Differenz zwischen Sendeleistungssignal und Empfangsleistungssignal einen zweiten Referenzwert überschreitet, enthält.

6. Balancefilter nach Anspruch 5,
   **dadurch gekennzeichnet,**

   daß das Freigabesignal (EUPD) auch dem adaptiven Filter (5) zugeführt wird und
   daß das adaptive Filter (5) erst bei Auftreten des Freigabesignals (EUPD) adaptiert.

7. Balancefilter nach einem der Ansprüche 1 bis 6,
   **dadurch gekennzeichnet,**
   daß die Transfersteuereinrichtung (18, 19, 21, 22, 23, 24) eine Einrichtung (21) zur Betriebsartenerkennung aufweist, die das Signal am Eingang des adaptiven Filters (5) hinsichtlich Breitbandigkeit und Schmalbandigkeit auswertet und die bei Vorliegen eines breitbandigen Signals ein weiteres Freigabesignal (NMOD) für die Kopiersteuereinrichtung (18) bereitstellt.

8. Balancefilter nach Anspruch 7,
   **dadurch gekennzeichnet,**

   daß die Einrichtung (21) zur Betriebsartenerkennung eine mit dem Eingangssignal des adaptiven Filters (5) angesteuerte Filterbank (43) mit mehreren frequenzbandspezifischen Ausgängen,
   den Ausgängen der Filterbank nachgeschaltete, weitere Absolutwertbilder (44),
   diesen nachgeschaltete weitere Tiefpässe (45),
   einen mit den Ausgängen der Tiefpässe (45) verbundenen Mittelwertbilder (46),
   eine dem Ausgang des Mittelwertbilders (46) nachgeschaltete Konstantenmultipliziereinrichtung (47),
   eine mit dem Ausgang der Konstantenmultipliziereinrichtung (47) und den Ausgängen der Tiefpässe (45) verbundene Auswerteeinrichtung (48), die die jeweils an den Ausgängen der Tiefpässe (45) anliegenden frequenzbandspezifischen Signale mit einem von der Konstantenmultipliziereinrichtung (47) abgegebenes Vergleichssignal vergleicht und bei Überschreiten des Vergleichssignals durch maximal zwei frequenzspezifische Signale ein Bandbreitensignal abgibt.

9. Balancefilter nach Anspruch 8,
   **dadurch gekennzeichnet,**
   daß ein Entscheider (49) das Bandbreitensignal und das Ausgangssignal eines Vergleichers (50) derart miteinander verknüpft, daß er bei Vorliegen eines der Breitbandigkeit des Signals am Eingang des adaptiven Filters (5) entsprechendes Bandbreitensignals und eines einer gewissen Echodämpfung entsprechenden Ausgangssignals des Vergleichers (50) das weitere Freigabesignal (NMODE) für die Kopiersteuereinrichtung (18) bereitstellt, wobei an einen Eingang des Vergleichers das Qualitätssignal (QUALS) und an den anderen Eingang ein der gewissen Echodämpfung entsprechendes Dämpfungsreferenzsignal (Limit) angelegt ist.

10. Balancefilter nach einem der Ansprüche 1 bis 9,
    **dadurch gekennzeichnet,**

# EP 0 729 229 B1

daß die Kopiersteuereinrichtung (18)

a) bei Ausbleiben des weiteren Freigabesignals (NMOD)

- einen internen Zähler zurücksetzt,
- ein Kopiersteuersignal (ECPY) für das Kopieren der Koeffizienten des adaptiven Filters (5) in das Hauptfilter (15) erzeugt,
- das Ausgangssignal (QUAL) des zweiten Tiefpasses (35) gleich dem Qualitätssignal (QUALS) setzt und
- eine Maximalwertvariable gleich dem Qualitätssignal (QUALS) setzt, ansonsten

b) bei Ausbleiben des ersten Freigabesignals (EUPD)

- den internen Zähler zurücksetzt ansonsten

c) wenn das Ausgangssignal (QUALS) des ersten Tiefpasses (33) größer ist als die Maximalwertvariable,

- den internen Zähler zurücksetzt,
- ein Kopiersteuersignal (ECPY) für das Kopieren der Koeffizienten des adaptiven Filters (5) in das Hauptfilter (15) erzeugt,
- das Ausgangssignal (QUAL) des zweiten Tiefpasses (35) gleich dem Qualitätssignal (QUALS) setzt und
- die Maximalwertvariable gleich dem Qualitätssignal (QUALS) setzt, ansonsten

d) wenn das Qualitätsdifferenzsignal größer ist als ein Qualitätsparameter,

- den internen Zähler zurücksetzt,
- das Kopiersteuersignal (ECPY) erzeugt,
- das Ausgangssignal (QUAL) des zweiten Tiefpasses (35) gleich dem Qualitätssignal (QUALS) setzt und
- die Maximalwertvariable gleich dem Qualitätssignal (QUALS) setzt.

11. Balancefilter nach Anspruch 10,
**dadurch gekennzeichnet,**
daß die Kopiersteuereinrichtung (18) ansonsten

e) wenn das Qualitätsdifferenzsignal (DQUAL) größer Null ist und daß Qualitätssignal (QUALS) größer einem Grenzwertparameter ist,

i) bei einem Zählerstand größer einem Zeitparameter

- den internen Zähler zurücksetzt,
- das Kopiersteuersignal (ECPY) erzeugt,
- das Ausgangssignal (QUAL) des zweiten Tiefpasses (35) gleich dem Qualitätssignal (QUALS) setzt und
- die Maximalwertvariable gleich dem Qualitätssignal (QUALS) setzt, und

ii) in den anderen Fällen

- den internen Zähler zurücksetzt, ansonsten

f) den Zähler zurücksetzt.

12. Balancefilter nach einem der Ansprüche 1 bis 11,
**dadurch gekennzeichnet**,
durch eine zumindest teilweise Realisierung als entsprechend programmierte Datenverarbeitungseinrichtung.

## Claims

1. Adaptive balanced filter

having an adaptive filter (5) which has a signal output, a coefficient output for outputting its filter coefficients, a fault signal input and a signal input which is coupled to a transmission path (7),

having a main filter (15) which has a signal output, a signal input which is coupled to the transmission path (7), and a coefficient input for loading filter coefficients, having a first subtractor (16) one of whose inputs is coupled to a receiving path (14) and whose other input is coupled to the output of the main filter (15), and whose output forms the further course (14') of the receiving path (14),

having a second subtractor (12) one of whose inputs is coupled to the receiving path (14), whose other input is coupled to the signal output of the adaptive filter (5) and whose output is coupled to the fault signal input of the adaptive filter (5),

having a transfer device (17) which is connected between the coefficient output of the adaptive filter (5) and the coefficient input of the main filter (15) and which has a control input for loading the filter coefficients of the adaptive filter (5) into the main filter (15) when an appropriate copying signal (ECPY) occurs, and

having a transfer control device (18, 19),

characterized

in that the transfer control device (18, 19) has three inputs (1, 2, 3), the first (1) of which is coupled to the output of the second subtractor (12), the second (2) of which is coupled to one input of the second subtractor (12), and the third of which is coupled to the output of the main filter (15),

in that the transfer control device (18, 19) uses the signals applied to the three inputs (1, 2, 3) to determine the echo attenuations of the adaptive filter (5) and main filter (15), compares the two echo attenuations with one another and, if the echo attenuation of the adaptive filter (5) is greater than that of the main filter (15), supplies an appropriate copying signal to the transfer device (17).

2. Balanced filter according to Claim 1,
characterized by

a first form filter (13) which is connected between one input of the second subtractor (12) and the receiving path (14),

by a second form filter (6) which has a transfer function identical to that of the first form filter (13) and which is connected between the transmission path (7) and the signal input of the adaptive filter (5), and

by a third form filter (20) which has a transfer function identical to that of the first form filter (13) and which is connected between the output of the main filter (15) and the third input (3) of the transfer control device.

3. Balanced filter according to Claim 1 or 2,
characterized in that

the transfer control device (18, 19) contains a quality comparison device (19),

having a third subtractor (25) one of whose inputs forms the second input (2) of the transfer control device and whose other input forms the third input (3) of the transfer control device,

having a first magnitude former (26), whose input forms the first input (1) of the transfer control device (18, 19),

having a second magnitude former (27), which input is connected to one input of the third subtractor (25),

having a third magnitude former (28) which is connected downstream of the third subtractor (25),

having a first, a second and a third logarithm former (29, 30, 31) which are respectively connected downstream of a first, a second and a third magnitude former (26, 27, 28),

having a fourth subtractor (32), whose inputs are respectively connected to the outputs of the first and of the second logarithm former (29, 30),

having a fifth subtractor (34) whose inputs are respectively connected to the outputs of the second and of the third logarithm former (30, 31),

having a first and a second low-pass filter (33, 35) which are respectively connected downstream of a fourth and a fifth subtractor (32, 34),

having a subtractor (36) whose inputs are connected to the outputs of the first and of the second low-pass filter (33, 35),

and in that the transfer control device contains a copying control device (18) whose input is coupled to the output of the sixth subtractor (36), and which compares the quality difference signal (DQUAL) provided by the sixth subtractor (36) with a first comparison value and, if there is any discrepancy between the two in a specific direction, produces a copying signal (ECPY) for the transfer device (17), with the first comparison value then being set to be equal to the actual value of the quality difference signal (DQUAL).

4.  Balanced filter according to Claim 3,
    characterized
    in that a third low-pass filter (37) is connected downstream of the sixth subtractor (36).

5.  Balanced filter according to one of Claims 1 to 4,
    characterized

    in that the transfer control device (18, 19, 22, 23, 24) contains devices (24, 23) for determining the power levels of the transmission signal which is present at the input of the adaptive filter (5), and the power levels of the received signal which is present at one input of the second subtractor (12), and
    an enable device (22), which is connected downstream of the two devices (23, 24) for determining the transmitted and received power levels and emits an enable signal (EUPD) to the copying control device (18) in order to enable the copying signal (ECPY) if the transmission power signal exceeds a first reference value and the difference between the transmission power signal and the received power signal exceeds a second reference value.

6.  Balanced filter according to Claim 5,
    characterized

    in that the enable signal (EUPD) is also supplied to the adaptive filter (5), and
    in that the adaptive filter (5) carries out adaptation only when the enable signal (EUPD) occurs.

7.  Balanced filter according to one of Claims 1 to 6,
    characterized

    in that the transfer control device (18, 19, 21, 22, 23, 24) has a device (21) for operating mode identification, which device (21) evaluates whether the signal at the input of the adaptive filter (5) has a broad bandwidth or a narrow bandwidth and, if a broadband signal is present, provides a further enable signal (NMOD) for the copying control device (18).

8.  Balanced filter according to Claim 7,
    characterized

    in that the device (21) for operating mode identification contains a filter bank (43) which is actuated by the input signal of the adaptive filter (5) and has a number of frequency-band-specific outputs,
    further magnitude formers (44) which are connected downstream of the outputs of the filter bank,
    further low-pass filters (45) which are connected downstream of them,
    an averager (46) which is connected to the outputs of the low-pass filters (45),
    a constant multiplier device (47) which is connected downstream of the output of the averager (46),
    and an evaluation device (48) which is connected to the output of the constant multiplier device (47) and to the outputs of the low-pass filters (45), compares the respective frequency-band-specific signals which are present at the outputs of the low-pass filters (45) with a comparison signal emitted from the constant multiplier device (47) and emits a broadband signal if the comparison signal is exceeded by a maximum of two frequency-specific signals.

9.  Balanced filter according to Claim 8
    characterized
    in that a decision-maker (49) links the broadband signal and the output signal of a comparator (50) to one another in such a way that, when a broadband signal is present which corresponds to the signal at the input of the adaptive filter (5), having a broad bandwidth, and the output signal of the comparator (50) corresponds to a specific echo attenuation, it provides the further enable signal (NMODE) for the copying control device (18), with the quality signal (QUALS) being applied to one input of the comparator, and an attenuation reference signal (Limit) which corresponds to the specific echo attenuation being applied to the other input.

10. Balanced filter according to one of Claims 1 to 9,
    characterized
    in that the copying control device (18) carries out the following functions:

a) if the further enable signal (NMOD) remains off,

- resets an internal counter,
- produces a copying control signal (ECPY) for copying the coefficients of the adaptive filter (5) to the main filter (15),
- sets the output signal (QUAL) of the second low-pass filter (35) to be equal to the quality signal (QUALS), and
- sets a maximum value variable to be equal to the quality signal (QUALS), otherwise

b) if the first enable signal (EUPD) remains off,

- resets the internal counter, otherwise

c) if the output signal (QUALS) of the first low-pass filter (33) is greater than the maximum value variable,

- resets the internal counter,
- produces a copying control signal (ECPY) for copying the coefficients of the adaptive filter (5) to the main filter (15),
- sets the output signal (QUAL) of the second low-pass filter (35) to be equal to the quality signal (QUALS), and
- sets the maximum value variable to be equal to the quality signal (QUALS), otherwise

d) if the quality difference signal is greater than a quality parameter,

- resets the internal counter,
- produces the copying control signal (ECPY),
- sets the output signal (QUAL) of the second low-pass filter (35) to be equal to the quality signal (QUALS), and
- sets the maximum value variable to be equal to the quality signal (QUALS).

**11.** Balanced filter according to Claim 10,
characterized
in that the copying control device (18), otherwise

e) if the quality difference signal (DQUAL) is greater than zero and if the quality signal (QUALS) is greater than a limit-value parameter,

i) and if a count is greater than a time parameter,

- resets the internal counter,
- produces the copying control signal (ECPY),
- sets the output signal (QUAL) of the second lowpass filter (35) to be equal to the quality signal (QUALS), and
- sets the maximum value variable to be equal to the quality signal (QUALS), and

ii) in other cases

- resets the internal counter, otherwise

f) resets the counter.

**12.** Balanced filter according to one of Claims 1 to 11,
characterized
by at least partial implementation as an appropriately programmed data processing device.

**Revendications**

1. Filtre d'équilibrage adaptatif

comportant un filtre (5) adaptatif qui comporte une sortie de signal, une sortie de coefficient pour l'émission de ses coefficients de filtre, une entrée de signal d'erreur ainsi qu'une entrée de signal couplée à une voie (7) d'émission,
comportant un filtre (15) principal qui comporte une sortie de signal, une entrée de signal couplée à la voie (7) d'émission ainsi qu'une entrée de coefficients pour charger des coefficients de filtre,
comportant un premier soustracteur (16), dont l'une des entrées est couplée à une voie (14) de réception et dont l'autre entrée est couplée à la sortie du filtre (15) principal et dont la sortie forme le parcours (14') ultérieur de la voie (14) de réception,
comportant un deuxième soustracteur (12) dont une des entrées est couplée à la voie (14) de réception, dont l'autre entrée est couplée à la sortie de signal du filtre (5) adaptatif et dont la sortie est couplée à l'entrée de signal d'erreur du filtre (5) adaptatif,
comportant un dispositif (17) de transfert qui est monté entre la sortie de coefficient du filtre (5) adaptatif et l'entrée de coefficient du filtre (15) principal et qui comporte une entrée de commande pour charger les coefficients de filtre du filtre (5) adaptatif dans le filtre (15) principal en cas d'apparition d'un signal (ECPY) de copiage correspondant et
comportant un dispositif (18, 19) de commande de transfert,

caractérisé en ce que le dispositif (18, 19) de transfert comporte trois entrées (1, 2, 3) dont la première (1) est couplée à la sortie du deuxième soustracteur (12), dont la deuxième (2) est couplée à l'une des entrées du deuxième soustracteur (12) et dont la troisième est couplée à la sortie du filtre (15) principal, en ce que le dispositif (18, 19) de commande de transfert détermine à partir des signaux s'appliquant aux trois entrées (1, 2, 3) les affaiblissements d'écho du filtre (5) adaptatif et du filtre (15) principal, compare les deux affaiblissements d'écho l'un à l'autre et, dans le cas d'un affaiblissement d'écho du filtre (5) adaptatif supérieur à celui du filtre (15) principal, envoie au dispositif (17) de transfert un signal de copiage correspondant.

2. Filtre d'équilibrage suivant la revendication 1, caractérisé par

un premier filtre (13) de mise en forme qui est monté entre l'une des entrées du deuxième soustracteur (12) et la voie (14) de réception,
par un deuxième filtre (6) de mise en forme qui a un comportement de transfert identique à celui du premier filtre (13) de mise en forme et qui est monté entre la voie (7) d'émission et l'entrée de signal du filtre (5) adaptatif et
par un troisième filtre (20) de mise en forme qui a un comportement de transfert identique à celui du premier filtre (13) de mise en forme et qui est monté entre la sortie du filtre (15) principal et la troisième entrée (3) du dispositif de commande de transfert.

3. Filtre d'équilibrage suivant la revendication 1 ou 2, caractérisé en ce que le dispositif (18, 19) de commande de transfert comporte un dispositif (19) de comparaison de qualité, comportant un soustracteur (25) dont l'une des entrées forme la deuxième entrée (2) et dont l'autre entrée forme la troisième entrée (3) du dispositif de commande de transfert, comportant un premier générateur (26) de valeur absolue dont l'entrée forme la première entrée (1) du dispositif (18, 19) de commande de transfert, comportant un deuxième générateur (27) de valeur absolue dont l'entrée est reliée à l'une des entrées du troisième soustracteur (25), comportant un troisième générateur (28) de valeur absolue qui est monté en aval du troisième soustracteur (25), comportant un premier, un deuxième et un troisième dispositif (29, 30, 31) pour prendre le logarithme qui sont montés en aval respectivement du premier, du deuxième et du troisième générateur (26, 27, 28) de valeur absolue, comportant un quatrième soustracteur (32) dont les entrées sont reliées aux sorties du premier et du deuxième dispositif (29, 30) pour prendre le logarithme, comportant un cinquième soustracteur (34) dont les entrées sont reliées aux sorties du deuxième et du troisième dispositif (30, 31) pour prendre le logarithme, comportant un premier et un deuxième passe-bas (33, 35) qui sont montés en aval respectivement du quatrième et du cinquième soustracteur (32, 34), comportant un soustracteur (36) dont les entrées sont reliées aux entrées du premier et du deuxième passe-bas (33, 35) et en ce que le dispositif de commande de transfert contient un dispositif (18) de commande de copiage dont l'entrée est couplée à la sortie du sixième soustracteur (36), qui compare le signal (DQUAL) de différence de qualité mis à disposition par le sixième soustracteur (36) à une première valeur de comparaison et qui, en cas d'écart des deux l'un par rapport à l'autre dans une direction déterminée, produit un signal (ECPY) de copiage pour le dispositif (17) de transfert, la première valeur de comparaison étant alors mise à la même valeur que la valeur du moment du signal DQUAL de différence de qualité.

4.  Filtre d'équilibrage suivant la revendication 3, caractérisé en ce qu'un troisième passe-bas (37) est monté en aval du sixième soustracteur (36).

5.  Filtre d'équilibrage suivant l'une des revendications 1 à 4, caractérisé en ce que le dispositif (18, 19, 22, 23, 24) de commande de transfert contient des dispositifs (24, 23) pour déterminer les puissances du signal d'émission s'appliquant à l'entrée du filtre (5) adaptatif et du signal de réception s'appliquant à l'une des entrées du deuxième soustracteur (12) ainsi qu'un dispositif (22) de libération qui est monté en aval des deux dispositifs (23, 24) pour déterminer la puissance d'émission et la puissance de réception et qui fournit un signal (EUPD) de libération au dispositif (18) de copiage pour libérer le signal (ECPY) de copiage si le signal de puissance d'émission est supérieur à une première valeur de référence et la différence entre le signal de puissance d'émission et le signal de puissance de réception est supérieur à une deuxième valeur de référence.

6.  Filtre d'équilibrage suivant la revendication 5, caractérisé en ce que le signal (EUPD) de libération est envoyé aussi au filtre (5) adaptatif et en ce que le filtre (5) adaptatif ne réalise une adaptation qu'à l'apparition du signal (EUPD) de libération.

7.  Filtre d'équilibrage suivant l'une des revendications 1 à 6, caractérisé en ce que le dispositif (18, 19, 21, 22, 23, 24) de commande de transfert comporte un dispositif (21) pour la reconnaissance du mode de fonctionnement qui exploite le signal à l'entrée du filtre (5) adaptatif pour savoir s'il est à large bande ou à bande étroite et qui, en présence d'un signal à large bande, met à disposition un signal (NMOD) de libération supplémentaire pour le dispositif (18) de commande de copiage.

8.  Filtre d'équilibrage suivant la revendication 7, caractérisé en ce que le dispositif (21) pour la reconnaissance du genre de fonctionnement comporte un banc (43) de filtre commandé par le signal d'entrée du filtre (5) adaptatif et comportant plusieurs sorties spécifiques à une bande de fréquence, des générateurs (44) de valeur absolue supplémentaires, montés en aval des sorties du banc de filtre, des passe-bas (45) supplémentaires montés en aval de ces derniers, un générateur (46) de valeurs moyennes relié aux sorties des passe-bas (45), un dispositif (47) de multiplication par une constante monté en aval de la sortie du générateur (46) de valeurs moyennes, un dispositif (48) d'exploitation qui est relié à la sortie du dispositif (47) de multiplication par une constante et aux sorties des passe-bas (45), qui compare les signaux spécifiques et une bande de fréquences s'appliquant chaque fois aux sorties des passe-bas (45) à un signal de comparaison fournit par le dispositif (47) de multiplication par une constante et qui dans le cas où au maximum deux signaux spécifiques à une fréquence sont supérieurs au signal de comparaison, fournit un signal à large bande.

9.  Filtre d'équilibrage suivant la revendication 8, caractérisé en ce qu'un décideur (49) combine le signal à large bande et le signal de sortie d'un comparateur (50) de telle manière que, en présence d'un signal à large bande correspondant à la large bande du signal à l'entrée du filtre (5) adaptatif et d'un signal de sortie du comparateur (50) correspondant à un certain affaiblissement d'écho, met à disposition du dispositif (18) de commande de copiage le signal (NMODE) de libération supplémentaire, le signal (QUALS) de qualité étant appliquée à une entrée du comparateur et un signal limite (LIMIT) de référence d'affaiblissement correspondant au certain affaiblissement d'écho étant appliqué à l'autre entrée.

10. Filtre d'équilibrage suivant l'une des revendications 1 à 9, caractérisé en ce que le dispositif (18) de commande de copiage

    a) en cas d'absence du signal (NMOD) de libération supplémentaire

    -   remet à l'état initial un compteur interne,
    -   produit un signal (ECPY) de commande de copiage pour le copiage des coefficients du filtre (5) adaptatif dans le filtre (15) principal,
    -   met le signal (QUAL) de sortie du deuxième passe-bas (35) à une valeur égale à celle du signal (QUALS) de qualité et
    -   met une variable de valeur maximale à une valeur égale au signal (QUALS) de qualité, sinon

    b) en cas d'absence du premier signal (EUPD) de libération

- remet le compteur interne à l'état initial, sinon

c) si le signal (QUALS) de sortie du premier passe-bas (33) est supérieur à la variable de valeur maximale,

- remet le compteur interne à l'état initial,
- produit un signal (ECPY) de commande de copiage pour le copiage du coefficient du filtre (5) adaptatif dans le filtre (15) principal,
- met le signal (QUAL) de sortie du deuxième passe-bas (35) à une valeur égale à celle du signal (QUALS) de qualité et
- met la variable de valeur maximale à une valeur égale à la valeur égale au signal (QUALS) de qualité, sinon

d) si le signal de différence de qualité est supérieur à un paramètre de qualité,

- remet le compteur interne à l'état initial,
- produit le signal (ECPY) de commande de copiage,
- met le signal (QUAL) de sortie du deuxième passe-bas (35) à une valeur égale à celle du signal (QUALS) de qualité et
- met la variable de valeur maximale à une valeur égale à celle du signal (QUALS) de qualité.

11. Filtre d'équilibrage suivant la revendication 10, caractérisé en ce que le dispositif (18) de commande de copiage sinon

e) si le (DQUAL) de différence de qualité est supérieur à zéro et que le signal (QUALS) de qualité est supérieur à un paramètre de valeur limite,

i) pour un état du compteur supérieur à un paramètre de temps

- remet à l'état initial le compteur interne,
- produit le signal (ECPY) de commande de copiage,
- met le signal (QUAL) de sortie du deuxième passe-bas (35) à une valeur égale à celle du signal (QUALS) de qualité et
- met la variable de valeur maximale à une valeur égale à celle du signal (QUALS) de qualité, et

ii) dans les autres cas

- remet à l'état initial le compteur interne, sinon

f) remet à l'état initial le compteur.

12. Filtre d'équilibrage suivant l'une des revendications 1 à 11, caractérisé par une réalisation au moins partielle en dispositif de traitement de données programmé en conséquence.

FIG 1

FIG 2

FIG 3

FIG 4